# EUROPEAN PATENT APPLICATION

(11) **EP 1 555 750 A2**
(43) Date of publication of application: **20.07.2005**
(21) Application number: 05000338.3
(22) Date of filing: 10.01.2005
(51) Int. Cl.: H03G 3/34

(54) **Noise eliminator**

(30) Priority: 15.01.2004 JP 2004007961
(71) Applicant: Pioneer Corporation, Meguro-ku, Tokyo (JP)
(72) Inventor: Akiyama, Kiichiro, Yamada Kawagoe-shi, Saitama-ken 350-8555 (JP)
(74) Representative: Popp, Eugen, Dr.

(57) **Abstract**

A noise eliminator (1) comprises: a noise detection unit (2) for detecting the pulsed noise mixed in a reception signal (S1), and detecting the period (τ) of occurrence of the pulsed noise; a detuning frequency detection unit (4) for detecting an adjacent interference signal superimposed on the reception signal (S1), and detecting a detuning frequency (ΔF) between the frequency (Fu) of the adjacent interference signal and the frequency (Fd) of a desired signal; a gate control unit (5) for calculating a period (m/ΔF) approximated to the period (τ) of occurrence of the pulsed noise as a gate period (τs), the gate period (τs) being an integer (m) multiple of the period (1/ΔF) equivalent to the reciprocal of the detuning frequency (ΔF) ; and a gate unit (2) for interrupting the pulsed noise mixed in the reception signal (S1) during the gate period (τs) , thereby outputting a reception signal (S2) of which pulsednoiseiseliminated. Thus, the noise eliminator (1) canreduce the effect of a spurious signal ascribable to an adjacent interference signal, thereby reducing pulsed noise mixed in a reception signal (S1) with reliability.

## Description

### BACKGROUND OF THE INVENTION

The present invention relates to a noise eliminator for eliminating noise mixed in a signal to be processed inside a receiver.

In general, it is technically important for receivers to perform signal processing based on noise-eliminated reception signals.

To give a concrete example, an in-car radio receiver to be mounted on an automobile is provided with a noise eliminator for eliminating pulsed noise such as ignition noise mixed in an intermediate frequency signal (IF signal), so that signal processing is performed based on the noise-reduced IF signal (see Japanese Patent Application Laid-Open No. Hei6-112853; hereinafter, referred to as patent document).

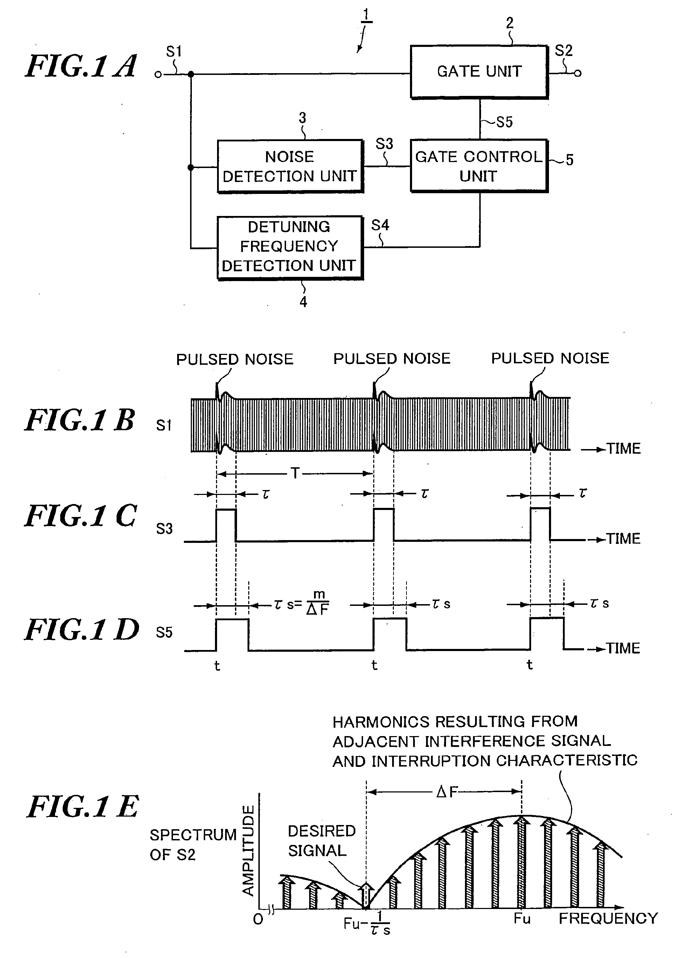

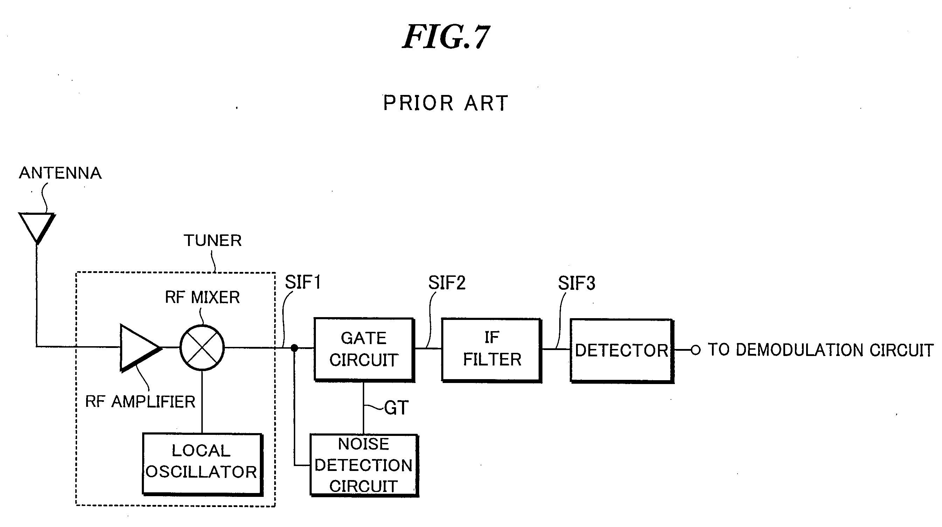

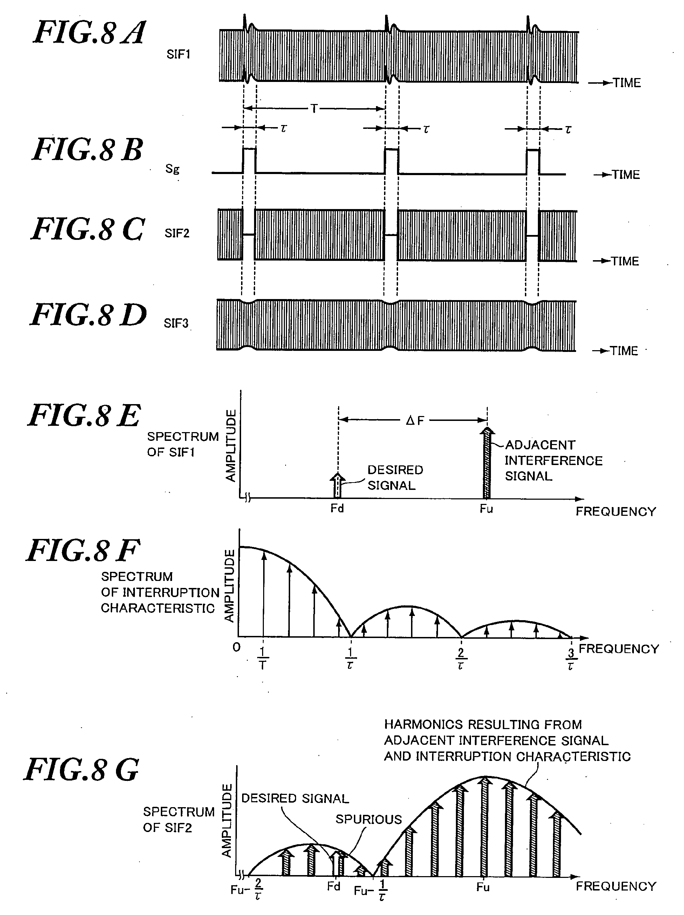

Fig. 7 is a block diagram showing the schematic configuration of a receiver to which the noise eliminator shown in Fig. 1 of the patent document is applied. Figs. 8A to 8G are waveform charts for explaining the operation of the noise eliminator.

In Fig. 7, the noise eliminator comprises a gate circuit and a noise detection circuit which are connected with the output of a tuner.

When an IF signal SIF1 in which such pulsed noise as shown in Fig. 8A is mixed is input to the noise detection circuit, the noise detection circuit detects the periods τ of occurrence of the pulsed noise, and outputs a gate control signal GT of rectangular waveform as shown in Fig. 8B. Next, according to the gate control signal GT, the gate circuit interrupts the passing of the pulsed noise mixed in the IF signal SIF1 during the periods τ of occurrence, whereby an IF signal SIF2 of which the pulsed noise is eliminated is output and supplied to an IF filter.

Then, while the IF signal SIF2 passes through the IF filter having a predetermined passband, a desired signal SIF3 is extracted and supplied to a detector. A detection signal detected by the detector is output to a demodulation circuit and the like.

Now, in the conventional noise eliminator disclosed in the foregoing patent document, the pulsed noise included in the IF signal SIF1 is interrupted in the periods τ of occurrence of the pulsed noise based on the gate control signal GT. The output IF signal SIF2 is thus demodulated by the interruption characteristic.

More specifically, suppose that A (f) is the frequency spectrum of the IF signal SIF1 having no pulsed noise mixed therein, B(f) is the frequency spectrum of the interruption characteristic mentioned above, and C(f) is the frequency spectrum of the IF signal SIF2 of which the pulsed noise is eliminated, output from the noise eliminator. The frequency spectrum C (f) of the IF signal SIF2 ideally coincides with the frequency spectrum A(f), whereas it actually is one expressed as the product of the frequency spectra A(f) and B(f), or A(f) B(f). This can cause harmonic distortion and the like in the IF signal SIF2 due to the effect of the interruption characteristic.

Moreover, suppose the case where an adjacent interference signal is superimposed on and pulsed noise is mixed in the IF signal SIF1 output from the tuner. Here, the gate circuit interrupts the pulsed noise, the adjacent interference signal modulated by the foregoing interruption characteristic appears as a spurious signal in the IF signal SIF2.

For example, when an adjacent interference signal having a frequency Fu which is different from the frequency (in other words, intermediate frequency) Fd of the desired signal by a frequency ΔF is superimposed on the IF signal SIF1, the IF signal SIF1 exhibits such a frequency spectrum as shown in Fig. 8E. The foregoing interruption characteristic has a frequency spectrum which varies with the time width τ and period T of the gate control signal GT as parameters as shown in Fig. 8F.

Consequently, the IF signal SIF2 output from the gate circuit has such a frequency spectrum as shown in Fig. 8G, which is one expressed as the product of the frequency spectrum of the IF signal SIF1 shown in Fig. 8E, having the adjacent interference signal superimposed thereon, and the frequency spectrum of the interruption characteristic shown in Fig. 8F.

Then, as shown in Fig. 8G, the frequency spectrum of the desired signal and the frequency spectrum of the spurious signal ascribable to the adjacent interference signal overlap with each other at the frequency Fd. This produces the problem that even if the IF signal SIF2 of which the pulsed noise is eliminated is passed through the IF filter having its passband set to the intermediate frequency Fd, the desired signal is extracted with spurious signals mixed therein, which deteriorates the selectivity of the desired signal in the IF filter.

### SUMMARY OF THE INVENTION

The present invention has been achieved in view of the foregoing conventional problems. It is thus an obj ect of the present invention to provide a noise eliminator which reduces the effect of a spurious signal ascribable to an adjacent interference signal, for example, and eliminates pulsed noise mixed in the reception signal with higher reliability.

According to a first aspect of the present invention, a noise eliminator for eliminating pulsed noise mixed in a reception signal, comprises: a noise detection unit for detecting the pulsed noise mixed in the reception signal, and detecting a period of occurrence of the pulsed noise; a detuning frequency detection unit for detecting an adjacent interference signal superimposed on the reception signal, and detecting a detuning frequency between the frequency of the adjacent interference signal and the frequency of a desired signal; a gate control unit for calculating a period approximated to the period of occurrence of the pulsed noise as a gate period, the gate period being an integer multiple of a period equivalent to a reciprocal of the detuning frequency; and a gate unit for interrupting the pulsed noise mixed in the reception signal during the gate period, thereby outputting the reception signal of which pulsed noise is eliminated.

According to a second aspect of the present invention, in the noise eliminator according to the first aspect, the detuning frequency detection unit comprises: an oscillator for outputting an alternating signal having the same frequency as that of the desired signal; and a multiplier for mixing the alternating signal and the reception signal to detect the detuning frequency.

According to a third aspect of the present invention, in the noise eliminator according to the second aspect, the detuning frequency detection unit comprises: a sensing unit for sensing whether any adjacent interference signal is superimposed on the reception signal or not, based on a mixed signal of the alternating signal and the reception signal output from the multiplier; and a switching unit for making the gate control unit calculate a period approximated to the period of occurrence of the pulsed noise as the gate period, the gate period being an integer multiple of a period equivalent to the reciprocal of the detuning frequency when the sensing unit senses that the adjacent interference signal is superimposed, and making the gate control unit calculate a period approximated to the period of occurrence of the pulsed noise as the gate period, the gate period being an integer multiple of a period equivalent to the reciprocal of the same frequency as that of the desired signal when the sensing unit senses that the adjacent interference signal is not superimposed.

According to a fourth aspect of the present invention, in the noise eliminator according to the third aspect, the sensing unit comprises: an AM detector for subjecting the mixed signal to AM detection; and a comparator for detecting whether the adjacent interference signal is superimposed on the reception signal or not, based on the amplitude of a signal output from the AM detector.

According to a fifth aspect of the present invention, a noise eliminator for eliminating pulsed noise mixed in an RF signal, comprises: a noise detection unit for detecting the pulsed noise mixed in the RF signal, and detecting the period of occurrence of the pulsed noise; a detuning frequency detection unit for detecting an adjacent interference signal superimposed on the RF signal, and detecting a detuning frequency between the frequency of the adjacent interference signal and the frequency of a desired signal; a gate control unit for calculating a period approximated to the period of occurrence of the pulsed noise as a gate period, the gate period being an integer multiple of a period equivalent to the reciprocal of the detuning frequency; and a gate unit for stopping supply of a local oscillation signal to an RF multiplier for mixing the local oscillation signal and the RF signal, during the gate period.

According to a sixth aspect of the present invention, in the noise eliminator according to the fifth aspect, the detuning frequency detection unit comprises: a first multiplier for mixing the local oscillation signal and a signal having the same frequency as an intermediate frequency; and a second multiplier for mixing the RF signal and an output of the first multiplier to detect the detuning frequency between the frequency of the adjacent interference signal superimposed on the RF signal and the frequency of the desired signal.

### BRIEF DESCRIPTION OF THE DRAWINGS

These and other objects and advantages of the present invention will become clear from the following description with reference to the accompanying drawings, wherein:
Fig. 1A is a block diagram showing the configuration of a noise eliminator according to an embodiment of the invention, and Figs. 1B to 1E are charts for explaining the operation of the noise eliminator;
Fig. 2 is a block diagram showing the configuration of the noise eliminator according to a more specific practical example of the embodiment shown in Figs. 1A to 1E;
Figs. 3A to 3G are charts for explaining the operation of the noise eliminator shown in Fig. 2;
Fig. 4 is a block diagram showing the configuration of the noise eliminator according to a second practical example;
Figs. 5A to 5C are charts for explaining the operation of the noise eliminator shown in Fig. 4;
Fig. 6 is a block diagram showing the configuration of the noise eliminator according to a third practical example;
Fig. 7 is a diagram showing the configuration of a conventional noise eliminator; and
Figs. 8A to 8G are charts for explaining the operation of the conventional noise eliminator.

### DETAILED DESCRIPTION OF THE PREFERRED EMBODIMENTS

For one of preferred embodiments of the present invention, a noise eliminator to be incorporated in an in-car radio receiver or the like will be described with reference to Figs. 1A to 1E.

Fig. 1A is a block diagram showing the configuration of the noise eliminator according to the present embodiment. Figs. 1B to 1E are waveform charts for explaining the operation of the noise eliminator according to the present embodiment.

In Fig. 1A, this noise eliminator 1 comprises a gate unit 2, a noise detection unit 3, and a detuning frequency detection unit 4 which receive the reception signal output from an internal tuner (not shown) of the receiver, or an IF signal S1, and a gate control unit 5.

The noise detection unit 3 detects pulsed noise such as ignition noise and thunderbolt noise when any is mixed in the IF signal S1, and outputs a noise detection signal S3 for indicating the periods τ of occurrence of the pulsed noise.

The detuning frequency detection unit 4 detects the frequency Fu of an adjacent interference signal superimposed on the IF signal S1. The detuning frequency detection unit 4 also detects a frequency difference (hereinafter, referred to as "detuning frequency") ΔF between the frequency Fu and the frequency Fd of a desired signal, and outputs a detuning frequency detection signal S4 for indicating the detuning frequency ΔF.

The gate control unit 5 receives the noise detection signal S3 and the detuning frequency detection signal S4, and calculates periods (m/ΔF) which are m (integer) times the reciprocal of the detuning frequency ΔF, or (1/ΔF), and are the closest to the periods τ of occurrence of the pulsed noise, respectively. The gate control unit 5 then outputs a gate control signal S5 of rectangular waveform, having gate periods τs which extend from the times t of occurrence of the respective noise pulses to when the periods (m/ΔF) have elapsed.

The gate unit 2 interrupts the passing of the pulsed noise mixed in the IF signal S1 during the gate periods τs indicated by the gate control signal S5, and lets the IF signal S1 pass during periods other than the gate periods τs. The gate unit 2 thus outputs an IF signal S2 of which pulsed noise is eliminated.

Next, description will be given of the operation of the noise eliminator 1 having the foregoing configuration.

For example, when an adjacent interference signal is superimposed on the IF signal S1 and relatively periodic pulsed noise such as ignition noise is mixed in as shown in Fig. 1B, the noise detection unit 3 detects the time t of occurrence and the period τ of occurrence of the noise pulse by pulse, and outputs a noise detection signal S3 of rectangular waveform as shown in Fig. 1C.

Moreover, the detuning frequency detection unit 4 detects the frequency Fu of the adjacent interference signal, detects the detuning frequency ΔF, or the frequency difference between the detected frequency Fu and the frequency Fd of the desired signal, and outputs the detuning frequency detection signal S4.

Then, the gate control unit 5 calculates the period (m/ΔF), which is m (integer) times the reciprocal of the detuning frequency ΔF, or (1/ΔF), and is the closest to the period τ, with respect to each pulse of the noise. The gate control unit 5 thus outputs the gate control signal S5 of rectangular waveform in which the gate period τs is set at the elapsed time of the period (m/ΔF) since the time t of occurrence of the noise pulse by pulse.

Suppose, for example, that the three pulses of noise shown in Fig. 1C have periods τ of occurrence of 1 msec, 2 msec, and 3 msec in order of elapsed time, respectively. For the gate period τs for eliminating the pulsed noise of 1 msec, the gate control unit 5 calculates a period (m/ΔF) which is m (integer) times the reciprocal of the detuning frequency ΔF and is the closest to 1 msec. For the gate period τs for eliminating the pulsed noise of 2 msec, the gate control unit 5 then calculates a period (m/ΔF) which is m (integer) times the reciprocal of the detuning frequency ΔF and is the closest to 2 msec. For the gate period τs for eliminating the pulsed noise of 3 msec, the gate control unit 5 then calculates a period (m/ΔF) which is m (integer) times the reciprocal of the detuning frequency ΔF and is the closest to 3 msec. The gate control unit 5 thus outputs the gate control signal S5 of rectangular waveform as shown in Fig. 1D.

Then, the gate unit 2 interrupts the passing of the pulsed noise mixed in the IF signal S1 during the individual gate periods τs indicated by the gate control signal S5, and lets the IF signal S1 pass during periods other than the gate periods τs. The gate unit 2 thus outputs the IF signal S2 of which pulsed noise is eliminated.

This noise eliminator 1 provides the following effects.

When the IF signal S1 on which an adjacent interference signal is superimposed and in which pulsed noise is mixed is input to the gate unit 2, the gate unit 2 interrupts the pulsed noise during the gate periods τs for elimination. As shown in Fig. 1E, the IF signal S2 output from the gate unit 2 has a frequency spectrum expressed as the product of the frequency spectrum of the interruption characteristic in the gate periods τs and the frequency spectrum of the IF signal S1 on which the adjacent interference signal is superimposed.

More specifically, the frequency spectrum of the interruption characteristic is the same as the Fourier transform of the gate control signal S2 of rectangular waveform shown in Fig. 1D, exhibiting the harmonic characteristic of large attenuations at frequencies m (integer) times the frequency of 1/τs, i.e., 1/τs, 2/τs, 3/τs, .... . Meanwhile, the frequency spectrum of the IF signal S1 on which the adjacent interference signal is superimposed includes those of the desired wave having the frequency Fd and the adjacent interference signal having the frequency Fu. Consequently, the frequency spectrum of the IF signal S2 is expressed as the product of the frequency spectrum of the foregoing interruption characteristic and the frequency spectrum of the IF signal S1 on which the adjacent interference signal is superimposed, or as shown in Fig. 1E.

Then, as shown in Fig. 1E, the spurious signal ascribable to the adjacent interference signal occurs at the frequency Fu while the desired signal occurs at a frequency of {Fu - (1/τs)} . In addition, the frequency spectrum of the harmonics included in the IF signal S2, resulting from the interruption characteristic, makes a significant attenuation at the frequency of {Fu - (1/τs)}.

Consequently, the desired signal in the IF signal S2 is no longer susceptible to the spurious signal ascribable to the adjacent interference signal and the harmonics ascribable to the interruption characteristic. When the IF signal S2 is passed through the IF f ilter, the desired signal containing no pulsed noise or spurious signals can be extracted and supplied to a detector or the like without deteriorating the selectivity of the IF filter.

That is, since the frequency {Fu - (1/τs)} of the desired signal shown in Fig. 1E is different from the frequency Fu of the adjacent interference signal by the detuning frequency ΔF, it coincides with the passband Fd of the IF filter provided in the receiver. As a result, even if any filter or the like having a special pass frequency band for extracting the desired signal in the IF signal S2 is not connected to the subsequent stage of this noise eliminator 1, it is possible to extract the desired signal containing no pulsed noise or spurious signals from the IF signal S2 and supply it to the detector or the like with no deterioration in selectivity by simply connecting an ordinary IF filter provided in the receiver.

### [Practical example 1]

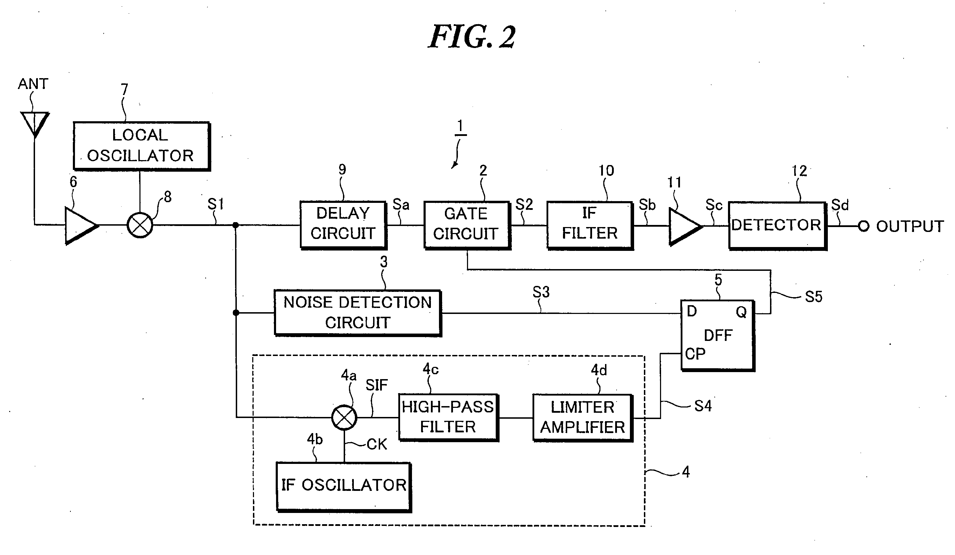

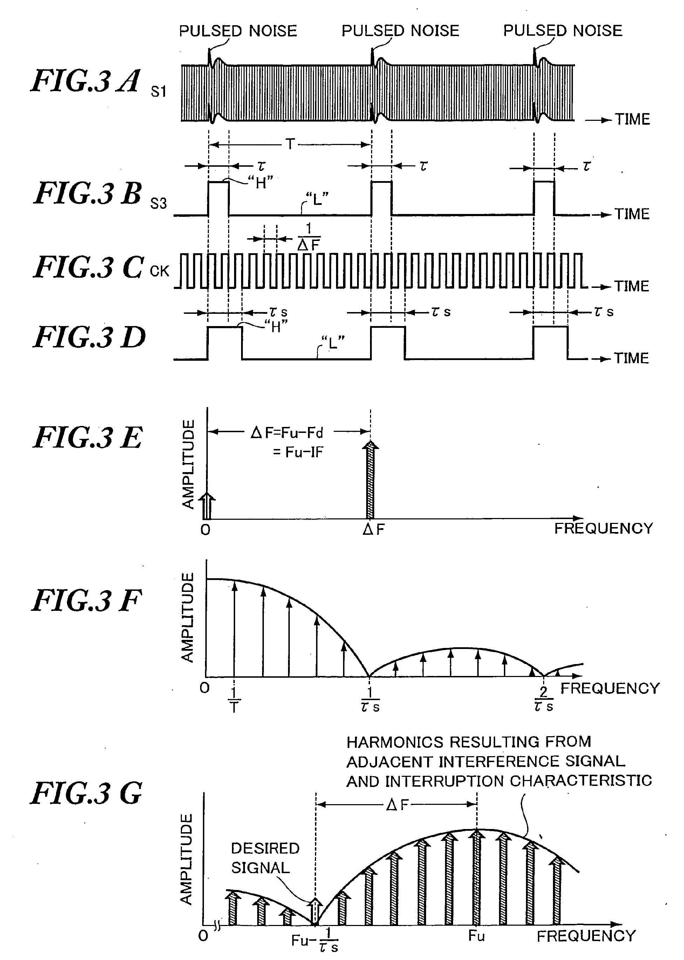

Next, a more specific practical example of the foregoing embodiment will be described with reference to Figs. 2 to 3G. Fig. 2 is a block diagram showing the configuration of a receiver which is provided with the noise eliminator of this practical example. Figs. 3A to 3G are waveform charts for explaining the operation of the noise eliminator. In Fig. 2, parts identical or equivalent to those of Fig. 1A are designated by the same reference numerals.

Initially, the configuration of the receiver will be overviewed with reference to Fig. 2. An RF multiplier 8 is connected to the output of an RF amplifier 6 which is connected with a reception antenna ANT. Then, the RF multiplier 8 mixes an RF signal output from the RF amplifier 6 and a local oscillation signal output from a local oscillator 7 to output a frequency-converted IF signal S1.

An IF filter 10, an IF amplifier 11, and a detector 12 are connected in series with the output of a gate circuit 2 to be described later.

Next, the configuration of the noise eliminator according to this practical example will be described in comparison with the noise eliminator shown in Fig. 1A.

This noise eliminator 1 comprises a gate circuit 2 corresponding to the gate unit 2 shown in Fig. 1A, a noise detection circuit 3 corresponding to the noise detection unit 3 shown in Fig. 1A, a detuning frequency detection circuit 4 corresponding to the detuning frequency detection unit 4 shown in Fig. 1A, and a D flip-flop 5 corresponding to the gate control unit 5 shown in Fig. 1A. Moreover, the detuning frequency detection circuit 4 comprises an IF multiplier 4a, an IF oscillator 4b, a high-pass filter 4c, and a limiter amplifier 4d.

A delay circuit 9 has a predetermined delay time equal to the internal delay time of the noise detection circuit 3, the detuning frequency detection circuit 4, and the D flip-flop (hereinafter, referred to as "DFF") 5. The delay circuit 9 delays the IF signal S1 output from the RF multiplier 8 and supplies the resultant to the gate circuit 2, thereby adjusting the timing of pulsed noise elimination processing in the gate circuit 2 to be described later.

The noise detection circuit 3 detects the periods τ of occurrence of pulsed noise mixed in the IF signal S1, and outputs a noise detection signal S3 of rectangular waveform which turns to "H" in logic during the periods τ of occurrence alone.

To be more specific, the noise detection circuit 3 comprises an amplitude detector, a high-pass filter, a low-pass filter, an amplifier, and a comparator which are not shown. The amplitude detector detects the IF signal S1. The high-pass filter extracts noise included in the output signal of the amplitude detector, in the range of frequencies higher than that of the desired signal. The low-pass filter smoothens the noise of higher frequencies in the output signal of the amplitude detector, thereby generating a smoothened signal near direct current. The amplifier amplifies the smoothened signal at a predetermined gain. The comparator compares the amplitude of the amplified smoothened signal and that of the output signal of the high-pass filter. Then, the comparator detects the periods in which the amplitude of the output signal of the high-pass filter exceeds that of the amplified smoothened signal as the periods τ of occurrence of the pulsed noise, and outputs a noise detection signal S3.

The IF oscillator 4b is made of an oscillator for outputting an alternating signal CKhaving the same frequency as the intermediate frequency.

The IF multiplier 4a is made of a multiplier. It multiplies (mixes) the IF signal S1 and the alternating signal CK to generate and output a mixed signal SIF which is the IF signal S1 frequency-converted based on the alternating signal CK.

For example, an IF signal S1 having an adjacent interference signal superimposed thereon is input to the IF multiplier 4a, the IF multiplier 4a frequency-converts the foregoing desired signal included in the IF signal S1 and the adjacent interference signal into the baseband frequency and the detuning frequency ΔF, respectively. Then, the frequency-converted mixed signal SIF is supplied to the high-pass filter 4c.

The high-pass filter 4c is made of a high-pass filter which passes signal components in the range of frequencies higher than that of the baseband desired signal included in the mixed signal SIF.

The limiter amplifier 4d limits the amplitude of the signal passed through the high-pass filter 4c, thereby outputting a wave-shaped binary signal, or a detuning frequency detection signal S4.

When the foregoing mixed signal SIF including the frequency-converted adjacent interference signals is input to the high-pass filter 4c, the high-pass filter 4c passes and outputs the adjacent interference signal having the same frequency as the detuning frequency ΔF described above. In addition, the limiter amplifier 4d limits the amplitude of the adjacent interference signal, thereby outputting the detuning frequency detection signal S4 of rectangular waveform which makes logic inversions at periods equivalent to the reciprocal of the 0detuning frequency ΔF, or (1/ΔF).

The DFF 5 receives the noise detection signal S3 and the detuning frequency detection signal S4 at its input terminal D and clock input terminal CP, respectively, and outputs a gate control signal S5 from its output terminal Q.

To be more specific, suppose that the detuning frequency detection signal S4 which makes logic inversions at the foregoing periods of (1/ΔF) is input to the DFF 5 during the foregoing periods τ of occurrence in which the noise detection signal S3 is "H" in logic. Then, the DFF 5 outputs the gate control signal S5 of rectangular waveform which remains "H" in logic during the periods τs which are m (integer) times the period of (1/ΔF) and is longer than and the closest to the foregoing periods τ of occurrence (i.e., during the gate periods).

The gate circuit 2 is made of a switch element such as an analog switch. In the gate periods τs where the gate control signal S5 is "H" in logic, the switch element interrupts the passing of an IF signal Sa supplied from the delay circuit 9. In the periods other than the gate periods τs, i.e., while the gate control signal S5 is "L" in logic, the switch element passes the IF signal Sa.

Consequently, when the IF signal Sa having pulsed noise mixed therein is input to the gate circuit 2, the gate circuit 2 interrupts the passing of the pulsed noise according to the gate control signal S5 during the gate periods τs which are in synchronization with the periods τ of occurrence of the pulsed noise. As a result, the gate circuit 2 outputs the IF signal 2 of which pulse noise is eliminated, to the IF filter 10.

Now, an example of operation of the noise eliminator 1 according to this practical example having the foregoing configuration will be described with reference to Figs. 3A to 3G.

Suppose, for example, that the RF multiplier 8 outputs such an IF signal S1 as shown in Fig. 3A on which an adjacent interference signal is superimposed and in which pulsed noise is mixed. The noise detection circuit 3 detects the time of occurrence and the period τ of occurrence of the noise pulse by pulse, generates the noise detection signal S3 of rectangular waveform as shown in Fig. 3B, and supplies it to the input terminal D of the DFF 5.

The IF multiplier 4a mixes the IF signal S1 and the alternating signal CK output from the IF oscillator 4b to output the frequency-converted mixed signal SIF. The mixed signal SIF is passed through the high-pass filter 4c and the limiter amplifier 4d. As a result, the detuning frequency detection signal S4 of rectangular waveform as shown in Fig. 3C is generated and input to the clock input terminal CP of the DFF 5.

Then, based on the noise detection signal S3 and the detuning frequency detection signal S4, the DFF 5 generates the gate control signal S5 as shown in Fig. 3D and supplies it to the gate circuit 2 through the output terminal Q.

More specifically, the DFF 5 receives the noise detection signal S3 of rectangular waveform, which turns to "H" in logic during the period τ of occurrence of each pulse of the noise mixed in the IF signal S1, and the detuning frequency detection signal S4, which repeats logic inversions at periods equivalent to the reciprocal of the detuning frequency ΔF, or (1/ΔF). This is equivalent to so-called delay processing on the noise detection signal S3 based on the detuning frequency detection signal S4. As a result, the DFF 5 outputs the gate control signal S5 of rectangular waveform which remains "H" in logic during the periods τs which are m (integer) times the period (1/ΔF) and are longer than and the closest to the foregoing periods τ of occurrence (i.e., gate periods).

Next, the gate circuit 2 interrupts the passing of the pulsed noise mixed in the IF signal Sa supplied through the delay circuit 9 during the individual gate periods τs indicated by the gate control signal S5, and lets the IF signal Sa pass during periods other than the gate periods τs. The gate circuit 2 thus outputs the IF signal S2 of which pulsed noise is eliminated.

Then, when the IF signal S2 is input to the IF filter 10 having the passband set at the frequency of the desired signal (in other words, intermediate frequency), a desired signal Sb included in the IF signal S2 is extracted. The IF amplifier 11 then amplifies the extracted desired signal Sb into a signal Sc, which is input to the detector 12. The detector 12 outputs a detection signal Sd.

The noise eliminator 1 of this practical example provides the following effects.

Initially, suppose the case where pulsed noise occurring relatively periodically, such as ignition noise, is mixed in the IF signal S1, and an adjacent interference signal having a frequency Fu different from the frequency Fd of the desired signal by the detuning frequency ΔF is superimposed on the IF signal S1 as shown in Fig. 3A. Here, Fig. 3E shows the frequency spectrum of the mixed signal SIF output from the IF multiplier 4a. Fig. 3F shows the frequency spectrum of the interruption characteristic when the gate circuit 2 interrupts pulsed noise according to the gate control signal S5.

That is, in the frequency spectrum of the mixed signal SIF, the desired signal and the adjacent interference signal occur at the positions of the baseband frequency and the detuning frequency ΔF, respectively. The frequency spectrum of the interruption characteristic varies with the period T and the gate period τs of occurrence of the pulsed noise as parameters, and attenuates significantly at frequencies n (integer) times the reciprocal of the gate period τs, or (n/τs).

Consequently, the IF signal S2 of which pulsed noise is eliminated, output from the gate circuit 2, has the frequency spectrum expressed as the product of the frequency spectrum of the mixed. signal SIF and the frequency spectrum of the interruption characteristic as shown in Fig. 3G. Here, the spurious signal resulting from the adjacent interference signal included in the IF signal S2 occurs at the frequency Fu. The desired signal included in the IF signal S1, having the frequency of Fd, appears in the IF signal S2 at the position of the frequency {Fu - (1/τs)}. Moreover, the frequency spectrum of the harmonics included in the IF signal S2, resulting from the interruption characteristic, attenuates significantly at the frequency {Fu - (1/τs)}.

Thus, the desired signal in the IF signal S2 is no longer susceptible to the harmonics and spurious signals ascribable to the adjacent interference signal and the interruption characteristic.

As above, the gate periods τs are determined as periods which are m (integer) times the period equivalent to the reciprocal of the detuning frequency ΔF, or (1/ΔF), and are longer than and the closest to the respective periods τ of occurrence of the pulsed noise. These gate periods τs are used to approximate the periods τ of occurrence of the pulsed noise. As a result, it is possible to adjust the frequency spectrum of the IF signal S2 so that the desired signal shown in Fig. 3E occurs in accordance with the frequency (1/τs) at which the harmonics of the interruption characteristic shown in 5 Fig. 3F attenuate significantly.

Thus, when the IF signal S2 is supplied to the IF filter 10, it is possible to extract the desired signal containing no pulsed noise or spurious signals from the IF signal S2 and supply it to the detector 12 and the like without a deterioration in selectivity.

Moreover, since the frequency {Fu - (1/τs)} of the desired signal shown in Fig. 3G is different from the frequency Fu of the adjacent interference signal by the detuning frequency ΔF, it coincides with the passband Fd of the IF filter 10 provided in the receiver. This eliminates the need to provide an IF filter having a special pass frequency band for the sake of extracting the desired signal in the IF signal S2. It is possible to extract the desired signal containing no pulsed noise or spurious signals from the IF signal S2 and supply it to the detector or the like with no deterioration in selectivity by simply connecting the gate circuit 2 with the ordinary IF filter 10 provided in the receiver.

### [Practical example 2]

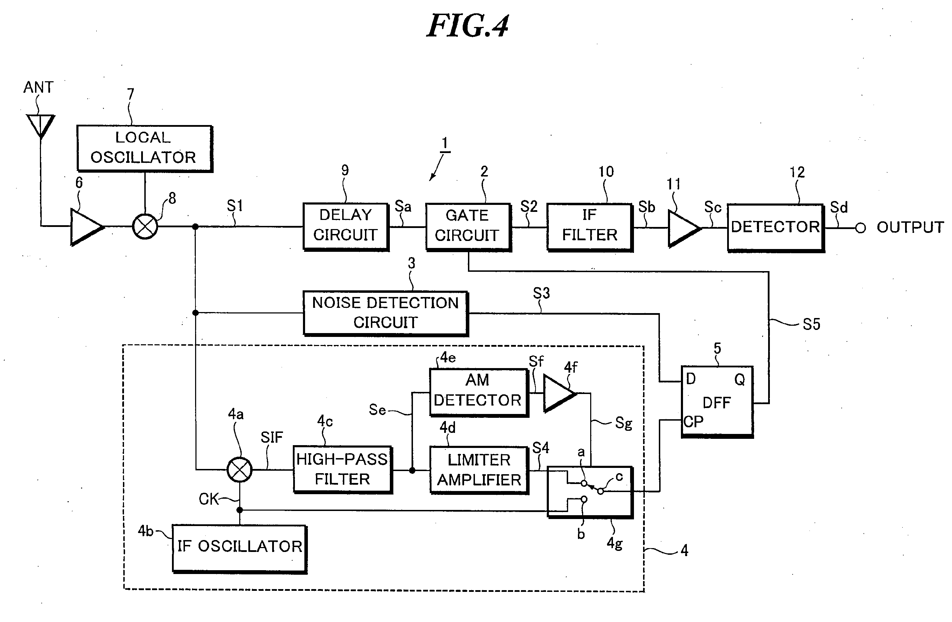

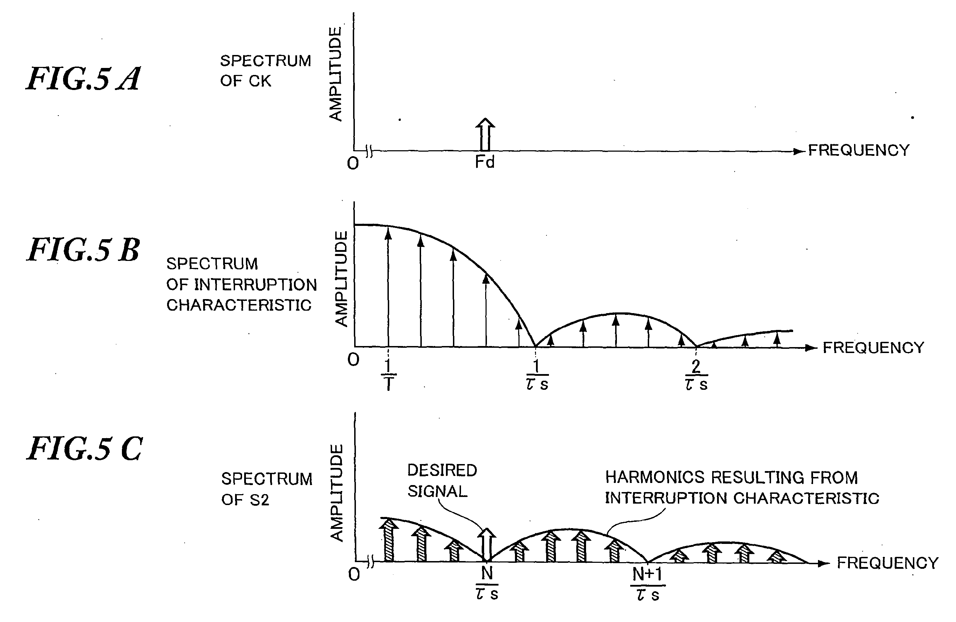

Next, the noise eliminator 1 according to a second practical example will be described with reference to Figs. 4 to 5C. Fig. 4 is a block diagram showing the configuration of a receiver which is provided with the noise eliminator of this practical example. Figs. 5A to 5C are waveform charts for explaining the operation of the noise eliminator. In Fig. 4, parts identical or equivalent to those of Figs. 1A and 2 are designated by the same reference numerals.

In Fig. 4, this noise eliminator 1 comprises a gate circuit 2, a noise detection circuit 3, a detuning frequency detection circuit 4, a DFF 5, and a delay circuit 9. The detuning frequency detection circuit 4 comprises an IF multiplier 4a, an IF oscillator 4b, a high-pass filter 4c, a limiter amplifier 4d, an AM detector 4e, a comparator 4f, and a switching circuit 4g. The AM detector 4e and the comparator 4f function as sensing means for sensing if any adjacent interference signal is superimposed on an IF signal S1.

That is, in terms of configuration, this noise eliminator 1 is different from the noise eliminator shown in Fig. 2 in that the detuning frequency detection circuit 4 is provided with the AM detector 4e, the comparator 4f, and the switching circuit 4g.

Here, the switching circuit 4g is made of an analog multiplexer or analog switch of two-input one-output type, which makes switching operations in accordance with a switch control signal Sg from the comparator 4f. One input terminal a is connected to the limiter amplifier 4d, and the other input terminal b to the IF oscillator 4b. The output terminal c is connected to the clock input terminal CP of the DFF 5. When the switching circuit 4g is switched to the input terminal a, the detuning frequency detection signal S4 which makes logic inversions at periods (1/ΔF), output from the limiter amplifier 4d, is transferred to the clock input terminal CP of the DFF 5. When the switching circuit 4g is switched to the input terminal b, the alternating signal CK having the same frequency as the intermediate frequency, output from the IF oscillator 4b, is transferred to the clock input terminal CP of the DFF 5.

The AM detector 4e subjects an adjacent interference signal Se output from the high-pass filter 4c to AM detection, and outputs the resulting AM detection signal Sf to the comparator 4f.

More specifically, the IF multiplier 4a mixes the IF signal S1 having the adjacent interference signal superimposed thereon and the alternating signal CK, and outputs the mixed signal SIF including the frequency-converted adjacent interference signal to the high-pass filter 4c. Then, the adjacent interference signal Se passed through the high-pass filter 4c is input to the AM detector 4e. The AM detector 4e subjects this adjacent interference signal Se to AM detection, thereby outputting the AM detection signal Sf to the comparator 4f.

The comparator 4f compares the amplitude of the AM detection signal Sf with a predetermined threshold, and outputs the result of comparison as the switch control signal Sg. If the amplitude of the AM detection signal Sf is greater than the threshold, the switching circuit 4g is switched to the input terminal a. If the amplitude of the AM detection signal Sf is smaller than the threshold, the switching circuit 4g is switched to the input terminal b.

Now, an example of operation of the noise eliminator 1 having the foregoing configuration will be described with reference to Figs. 3A to 3C.

Suppose, for example, that the RF multiplier 8 outputs such an IF signal S1 as shown in Fig. 3A on which an adjacent interference signal is superimposed and in which pulsed noise is mixed. The noise detection circuit 3 detects the time of occurrence and the period τ of occurrence of the noise pulse by pulse, generates the noise detection signal S3 of rectangular waveform as shown in Fig. 3B, and supplies it to the input terminal D of the DFF 5.

The IF multiplier 4a mixes the IF signal S1 and the alternating signal CK output from the IF oscillator 4b to output the frequency-converted mixed signal SIF. The mixed signal SIF is passed through the high-pass filter 4c and the limiter amplifier 4d. As a result, the detuning frequency detection signal S4 of rectangular waveform as shown in Fig. 3C is generated and input to the one input terminal a of the switching circuit 4g.

The AM detector 4e subjects the adjacent interference signal Se to AM detection, thereby outputting the AM detection signal Sf. The comparator 4f generates the switch control signal Sg from the AM detection signal Sf, so that the switching circuit 4g is switched to the input terminal a. Consequently, the detuning frequency detection signal S4 is input to the clock input terminal CP of the DFF 5 through the input terminal a of the switching circuit 4g.

Then, the DFF 5 receives the noise detection signal S3 and the detuning frequency detection signal S4 which repeats logic inversions at periods equivalent to the reciprocal of the detuning frequency ΔF, or (1/ΔF). As a result, the DFF 5 generates the gate control signal S5 of rectangular waveform which remains "H" in logic during the periods τs which are m (integer) times the period (1/ΔF) and are longer than and the closest to the foregoing periods τ of occurrence of the pulsed noise (i.e., the gate periods). The gate control signal S5 is supplied to the gate circuit 2.

Next, the gate circuit 2 interrupts the passing of the pulsed noise mixed in the IF signal Sa supplied through the delay circuit 9 during the individual gate periods τs indicated by the gate control signal S5, and lets the IF signal Sa pass during periods other than the gate periods τs. The gate circuit 2 thus outputs the IF signal S2 of which pulsed noise is eliminated.

Up to this point, description has been given of the operation for situations where the RF multiplier 8 outputs the IF signal S1 on which an adjacent interference signal is superimposed and in which pulsed noise is mixed. When the RF multiplier 8 outputs an IF signal S1 on which no adjacent interference signal is superimposed but in which pulsed noise is mixed, the noise eliminator 1 makes the following operation.

Initially, the noise detection circuit 3 detects the time of occurrence and the period τ of occurrence of the noise pulse by pulse, generates the noise detection signal S3 of rectangular waveform as shown in Fig. 3B, and supplies it to the input terminal D of the DFF 5.

The IF multiplier 4a mixes the IF signal S1 and the alternating signal CK output from the IF oscillator 4b to output the frequency-converted mixed signal SIF. Note that since no adjacent interference signal is superimposed on the IF signal S1, the mixed signal SIF does not contain any adjacent interference signal: Thus, even when the mixed signal SIF is passed through the high-pass filter 4c and the limiter amplifier 4d, such a detuning frequency detection signal S4 as shown in Fig. 3C is not supplied to the input terminal a of the switching circuit 4g.

In addition, the signal Se input from the high-pass filter 4c to the AM detector 4e does not contain any adjacent interference signal, either, so that the AM detection signal Sf output from the AM detector 4e becomes smaller in amplitude. The comparator 4f compares the AM detection signal SF and the threshold, and thus outputs the switch control signal Sg for switching the switching circuit 4g to the input terminal b.

Consequently, when no adjacent interference signal is superimposed on the IF signal S1, the alternating signal CK output from the IF oscillator 4b is input to the clock input terminal CP of the DFF 5 through the input terminal b of the switching circuit 4g.

Receiving the noise detection signal S3 and the alternating signal CK, the DFF 5 then generates the gate control signal S5 of rectangular waveform which remains "H" in logic during the periods τs which are integer multiples of the period equivalent to the reciprocal of the frequency of the alternating signal CK and are longer than and the closest to the foregoing periods τ of occurrence of the pulsed noise (i.e., the gate periods). The gate control signal S5 is supplied to the gate circuit 2.

Next, the gate circuit 2 interrupts the passing of the pulsed noise mixed in the IF signal Sa supplied through the delay circuit 9 during the individual gate periods τs indicated by the gate control signal S5, and lets the IF signal Sa pass during periods other than the gate periods τs. The gate circuit 2 thus outputs the IF signal S2 of which pulsed noise is eliminated.

As described above, in the noise eliminator 1 shown Fig. 4, the AM detector 4e and the comparator 4f detect whether or not any adjacent interference signal is superimposed on the IF signal S1. If any adjacent interference signal is superimposed on the IF signal S1, the gate circuit 2 interrupts the pulsed noise by using periods which are m (integer) times the period (1/ΔF) equivalent to the reciprocal of the detuning frequency ΔF and are longer than and the closest to respective periods τ of occurrence of the pulsed noise as the gate periods τs. If no adjacent interference signal is superimposed on the IF signal S1, the gate circuit 2 interrupts the pulsed noise by using periods which are integral multiples of the period equivalent to the reciprocal of the frequency (intermediate frequency) of the alternating signal CK and are longer than and the closest to respective periods τ of occurrence of the pulsed noise.

The noise eliminator 1 according to this practical example provides the following effects.

First, as described above, when pulsed noise is mixed in the IF signal S1 having no adjacent interference signal superimposed thereon, the AM detector 4e and the comparator 4f detect that no adjacent interference signal is superimposed on the IF signal S1. Meanwhile, the noise detection circuit 3 detects the periods τ of occurrence of the pulsed noise. Consequently, the noise detection signal S3 indicating the periods τ of occurrence is supplied to the input terminal D of the DFF 5, and the alternating signal CK having the same frequency as the intermediate frequency is supplied to the clock input terminal CP through the switching circuit 4g. Then, the DFF 5 makes the gate circuit 2 interrupt the pulsed noise by using the periods which are integer multiples of the period equivalent to the reciprocal of the frequency of the alternating signal CK and are longer than and the closest to the respective periods τ of occurrence of the pulsed noise as the gate periods τs.

Here, as shown in the frequency spectrum of Fig. 5A, the alternating signal CK occurs at the position of the intermediate frequency. As shown in Fig. 5B, the frequency spectrum of the interruption characteristic when the gate circuit 2 interrupts the pulsed noise makes large attenuations at frequencies which are integer multiples of the frequency (1/τs). Then, the IF signal S2 of which pulsed noise is eliminated, output from the gate circuit 2, exhibits the frequency spectrum expressed as the product of the frequency spectrum of the alternating signal CK and the frequency spectrum of the interruption characteristic as shown in Fig. 5C.

Then, as is evident from Fig. 5C, the harmonics ascribable to the interruption characteristic attenuate significantly at a frequency N (integer) times the frequency (1/τs), and the desired signal occurs right at the frequency of attenuation of the harmonics.

This makes the desired signal in the IF signal S2 insusceptible to the harmonics ascribable to the interruption characteristic. When the IF signal S2 is supplied to the IF filter 10, it is possible to extract the desired signal containing no pulsed noise from the IF signal S2 and supply it to the detector 12 and the like.

Second, when pulsed noise is mixed in and an adjacent interference signal superimposed on the IF signal S1, the AM detector 4e and the comparator 4f detect that the adjacent interference signal is superimposed on the IF signal S1. Meanwhile, the noise detection circuit 3 detects the periods τ of occurrence of the pulsed noise. Consequently, the noise detection signal S3 indicating the periods τ of occurrence is supplied to the input terminal D of the DFF 5, and the detuning frequency signal S4 is supplied to the clock input terminal CP through the switching circuit 4g. Then, the DFF 5 determines periods which are m (integer) times the period (1/ΔF) equivalent to the reciprocal of the detuning frequency ΔF and are longer than and the closest to the respective periods τ of occurrence of the pulsed noise as the gate periods τs. The DFF 5 eliminates the pulsed noise by controls the gate circuit 2 with the gate control signal S5 having the gate periods τs approximated to the periods τ of occurrence of the pulsed noise.

Consequently, the IF signal S2 output from the gate circuit 2 exhibits the same frequency spectrum as shown in Fig. 3G, so that the desired signal in the IF signal S2 becomes insusceptible to the harmonics and spurious signals ascribable to the adjacent interference signal and the interruption characteristic. When the IF signal S2 is supplied to the IF filter 10, it is possible to extract the desired signal containing no pulsed noise or spurious signals from the IF signal S2 and supply it to the detector 12 and the like without a deterioration in selectivity.

As above, according to the noise eliminator 1 of this practical example, it is possible to eliminate pulsed noise in both cases that the pulsed noise is mixed in the IF signal S1 having no adjacent interference signal superimposed thereon, and that the pulsed noise is mixed in and an adjacent interference signal is superimposed on the IF signal S1. It is also possible to extract the desired signal from the IF signal S2 and supply it to the detector 12 and the like without a deterioration in selectivity.

Furthermore, in the case of eliminating the pulsed noise mixed in the IF signal S1 having no adjacent interference signal superimposed thereon, the gate circuit 2 interrupts the pulsed noise by using the periods that are integer multiples of the period equivalent to the reciprocal of the frequency of the alternating signal CK and are longer than and the closest to the periods τ of occurrence of the pulsed noise as the gate periods τs. The frequency at which the harmonics of the interruption characteristic shown in Fig. 5C attenuate significantly can thus be matched with the frequency of the desired signal. It is therefore possible to extract the desired signal in a favorable manner and supply it to the detector and the like without affecting the interruption characteristic in eliminating the pulsed noise.

### [Practical example 3]

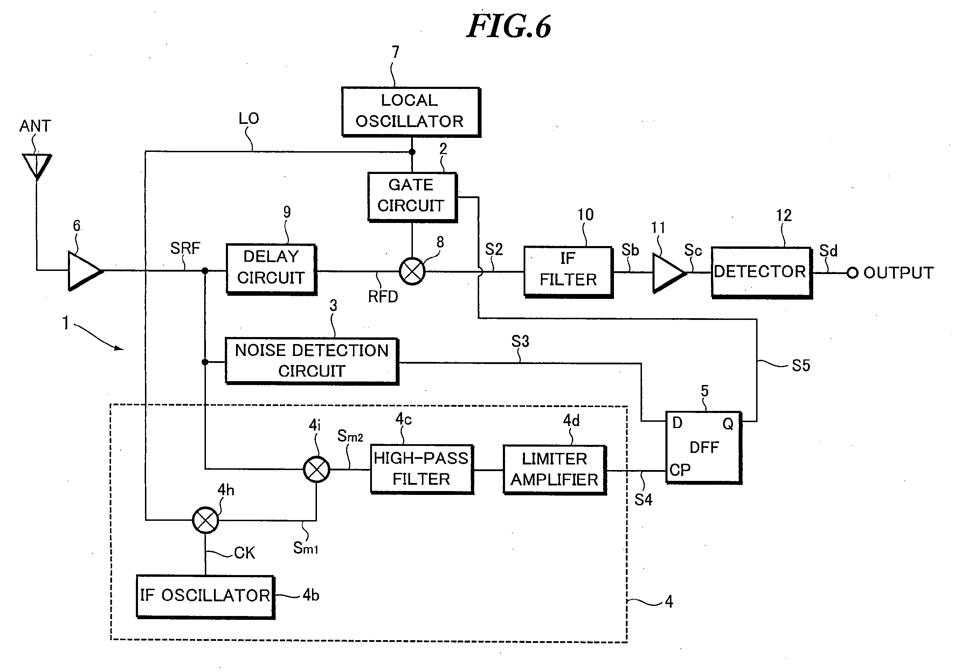

Next, the noise eliminator 1 according to a third practical example will be described with reference to Fig 6. Fig. 6 is a block diagram showing the configuration of a receiver which is provided with the noise eliminator of this practical example. In Fig. 6, parts identical or equivalent to those of Figs. 1A, 2, and 4 are designated by the same reference numerals.

In Fig. 6, this noise eliminator 1 comprises a gate circuit 2, a noise detection circuit 3, a detuning frequency detection circuit 4, a DFF 5, and a delay circuit 9. The gate circuit 2 is interposed between a local oscillator 7 and an RF multiplier 8. The delay circuit 9 is interposed between an RF amplifier 6 and the RF multiplier 8. Moreover, the detuning frequency detection circuit 4 comprises an IF oscillator 4b, first and second multipliers 4h and 4i, a high-pass filter 4c, and a limiter amplifier 4d.

The gate circuit 2 is made of an analog switch or the like which turns on during gate periods τs and turns off during periods other than the gate periods τs according to a gate control signal S5 supplied from the DFF 5. During the gate periods τs, a local oscillation signal LO output from the local oscillator 7 is supplied to the RF multiplier 8. In the periods other than the gate periods τs, the supply of the local oscillation signal LO to the RF multiplier 8 is stopped.

The delay circuit 9 is provided for the sake of timing adjustment, as in the first and second practical examples. It delays a reception signal output from the RF amplifier 6, or an RF signal SRF, by a predetermined time and supplies the resultant to the RF multiplier 8.

Consequently, the RF multiplier 8 mixes the RF signal SRF supplied through the delay circuit 9 and the local oscillation signal LO supplied through the gate circuit 2, thereby frequency-converting the RF signal SRF of radio frequency into an intermediate frequency signal S2, and supplies the resultant to an IF filter 10.

The noise detection circuit 3 detects pulsed noise mixed in the RF signal SRF, and supplies an input terminal D of the DFF 5 with a noise detection signal S3 of rectangular waveform which turns to "H" in level during the periods τ of occurrence of the pulses.

The IF oscillator 4b outputs the alternating signal CK having the same frequency as the intermediate frequency, and supplies it to the first multiplier 4h.

The first multiplier 4h is made of a multiplier. It multiplies (mixes) the local oscillation signal LO from the local oscillator 7 and the alternating signal CK to generate a signal (hereinafter, referred to as "first mixed signal") Sm1, and supplies it to the second multiplier 4i.

The second multiplier 4i is made of a multiplexer. It multiplies (mixes) the RF signal SRF and the first mixed signal Sm1 to generate a signal (hereinafter, referred to as "second mixed signal") Sm2, and supplies it to the high-pass filter 4c.

Now, when the first multiplier 4h multiplies (mixes) the local oscillation signal LO and the alternating signal CK, the first mixed signal Sm1 is generated with the frequency Fd of the desired signal. When the second multiplier 4i multiplies (mixes) the RF signal SRF and the first mixed signal Sm1, a signal having the frequency difference (Fu - Fd) between the frequency Fu of the adjacent interference signal superimposed on the RF signal SRF and the frequency Fd of the desired signal, or the detuning frequency ΔF, appears in the second mixed signal Sm2.

The high-pass filter 4c has a cutoff frequency for passing the signal having the foregoing detuning frequency ΔF, included in the second mixed signal Sm2. The high-pass filter 4c supplies the passed signal having the detuning frequency ΔF to the limiter amplifier 4d.

The limiter amplifier 4d limits the amplitude of the signal passed throughthe high-pass filter 4c, having the foregoing detuning frequency ΔF, and thereby outputs a wave-shaped binary signal, or a detuning frequency detection signal S4. More specifically, the limiter amplifier 4d generates a detuning frequency detection signal S4 which repeats logic inversions at periods equivalent to the reciprocal of the detuning frequency ΔF, or (1/ΔF), and supplies it to the clock input terminal CP of the DFF 5.

The DFF 5 receives the noise detection signal S3 indicating the periods τ of occurrence of the pulsed noise, output from the noise detection circuit 3, and the detuning frequency detection signal S4 from the limiter amplifier 4. The DFF 5 then performs so-called delay processing on the noise detection signal S3 based on the detuning frequency detection signal S4. As a result, the DFF 5 outputs the gate control signal S5 of rectangular waveform which remains "H" in logic during the periods τs which are m (integer) times the periods (1/ΔF) equivalent to the reciprocal of the detuning frequency ΔF and are longer than and the closest to the foregoing periods τ of occurrence.(i.e., gate periods).

Consequently, in the gate periods τs approximated to the periods τ of occurrence of the pulsed noise mixed in the RF signal SRF, the DFF 5 turns off the gate circuit 2 to stop the supply of the local oscillation signal LO to the RF multiplier 8. On the other hand, in the periods other than the gate periods τs, the DFF 5 turns on the gate circuit 2 so that the local oscillation signal LO is supplied to the RF multiplier 8.

According to the noise eliminator 1 of this practical example having the foregoing configuration, when an adjacent interference signal is superimposed on and pulsed noise is mixed in the RF signal SRF, the noise detection circuit 3 detects the periods τ of occurrence of the pulsed noise and outputs the noise detection signal S3. The detuning frequency detection circuit 4 detects the detuning frequency ΔF and outputs the detuning frequency detection signal S4. The DFF 5 outputs the gate control signal S5 for turning off the gate circuit 2 during the gate periods τs approximated to the periods τ of occurrence of the pulsed noise.

Consequently, when the gate circuit 2 is turned off during the gate periods τs, the RF multiplier 8 stops mixing the local oscillation signal LO and the pulsed noise which is mixed in the RF signal SRF supplied through the delay circuit 9, and outputs the IF signal S2 of which pulsed noise is eliminated.

In addition, the gate periods τs are ones m (integer) times the period (1/ΔF) equivalent to the reciprocal of the detuning frequency ΔF and are longer than and the closest to the foregoing periods τ of occurrence. This results in a coincidence between the frequency of the desired signal in the IF signal S2 and the frequency at which a large attenuation occurs in the frequency spectrum of the interruption characteristic when the gate circuit 2 is turned off to interrupt the supply of the local oscillation signal LO to the RF multiplier 8. Consequently, the desired signal in the IF signal S2 is no longer susceptible to the spurious signal ascribable to the adjacent interference signal and the harmonics ascribable to the interruption characteristic of the gate circuit 2. When the IF signal S2 is passed through the IF filter, the desired signal containing no pulsed noise or spurious signals can thus be extracted and supplied to the detector or the like without deteriorating the selectivity of the IF filter 10.

## Claims

1. A noise eliminator (1) for eliminating pulsed noise mixed in a reception signal (S1), **characterized by**:
noise detection means (3) for detecting the pulsed noise mixed in the reception signal (S1), and detecting a period (τ) of occurrence of the pulsed noise;
detuning frequency detection means (4) for detecting an adjacent interference signal superimposed on the reception signal (S1), and detecting a detuning frequency (ΔF) between the frequency (Fu) of the adjacent interference signal and the frequency (Fd) of a desired signal;
gate control means (5) for calculating a period (m/ΔF) approximated to the period (τ) of occurrence of the pulsed noise as a gate period (τs), the gate period (τs) being an integer (m) multiple of a period (1/ΔF) equivalent to a reciprocal of the detuning frequency (ΔF); and
gate means (2) for interrupting the pulsed noise mixed in the reception signal (S1) during the gate period (τs), thereby outputting the reception signal (S2) of which pulsed noise is eliminated.

2. The noise eliminator (1) according to claim 1, wherein
the detuning frequency detection means (4) comprises:
an oscillator (4b) for outputting an alternating signal (CK) having the same frequency as that (Fd) of the desired signal; and
a multiplier (4a) for mixing the alternating signal (CK) and the reception signal (S1) to detect the detuning frequency (ΔF).

3. The noise eliminator (1) according to claim 2, wherein
the detuning frequency detection means (4) comprises:
sensing means (4e, 4f) for sensing whether any adjacent interference signal is superimposed on the reception signal (S1) or not, based on a mixed signal (SIF) of the alternating signal (CK) and the reception signal (S1) output from the multiplier (4a) ; and
switching means (4g) for making the gate control means (5) calculate a period approximated to the period (τ) of occurrence of the pulsed noise as the gate period (τs), the gate period (τs) being an integer (m) multiple of a period (1/ΔF) equivalent to the reciprocal of the detuning frequency (ΔF) when the sensing means (4e, 4f) senses that the adjacent interference signal is superimposed, and making the gate control means (5) calculate a period approximated to the period (τ) of occurrence of the pulsed noise as the gate period (τs), the gate period (τs) being an integer multiple of a period equivalent to the reciprocal of the same frequency as that (Fd) of the desired signal when the sensing means (4e, 4f) senses that the adjacent interference signal is not superimposed.

4. The noise eliminator (1) according to claim 3, wherein
the sensing means (4e, 4f) comprises:
an AM detector (4e) for subjecting the mixed signal (SIF) to AM detection; and
a comparator (4f) for detecting whether the adjacent interference signal is superimposed on the reception signal (S1) or not, based on an amplitude of a signal output (Sf) from the AM detector (4e).

5. A noise eliminator (1) for eliminating pulsed noise mixed in an RF signal (SRF), **characterized by**:
noise detection means (3) for detecting the pulsed noise mixed in the RF signal (SRF), and detecting a period (τ) of occurrence of the pulsed noise;
detuning frequency detection means (4) for detecting an adjacent interference signal superimposed on the RF signal (SRF), and detecting a detuning frequency (ΔF) between the frequency (Fu) of the adjacent interference signal and the frequency (Fd) of a desired signal;
gate control means (5) for calculating a period (m/ΔF) approximated to the period (τ) of occurrence of the pulsed noise as a gate period (τs), the gate period (τs) being an integer (m) multiple of a period (1/ΔF) equivalent to a reciprocal of the detuning frequency (ΔF); and
gate means (2) for stopping supply of a local oscillation signal (LO) to an RF multiplier (8) for mixing the local oscillation signal (LO) and the RF signal (SRF), during the gate period (τs).

6. The noise eliminator (1) according to claim 5, wherein
the detuning frequency detection means (4) comprises:
a first multiplier (4h) for mixing the local oscillation signal (LO) and a signal (CK) having the same frequency as an intermediate frequency; and
a second multiplier (4i) for mixing the RF signal (SRF) and an output (Sm1) of the first multiplier (4h) to detect the detuning frequency (ΔF) between the frequency (Fu) of the adjacent interference signal superimposed on the RF signal (SRF) and the frequency (Fd) of the desired signal.
